Europäisches Patentamt

**European Patent Office**

Office européen des brevets

(19)

(11) Veröffentlichungsnummer : **0 150 541**
**B1**

(12) **EUROPÄISCHE PATENTSCHRIFT**

(45) Veröffentlichungstag der Patentschrift :
23.11.89

(21) Anmeldenummer : 84201939.0

(22) Anmeldetag : 24.12.84

(51) Int. Cl.⁴ : **G 01 N 24/06**, G 01 N 24/08

(54) **Kernspintomograph.**

(30) Priorität : 12.01.84 DE 3400861

(43) Veröffentlichungstag der Anmeldung :
07.08.85 Patentblatt 85/32

(45) Bekanntmachung des Hinweises auf die Patenterteilung : 23.11.89 Patentblatt 89/47

(84) Benannte Vertragsstaaten :
DE FR GB IT NL SE

(56) Entgegenhaltungen :
DE-A- 3 316 722
GB-A- 2 070 254
REVIEW OF SCIENTIFIC INSTRUMENTS, Band 53, Nr. 9, September 1982, Seiten 1338-1343, New York, US; J.R. FITZSIMMONS: "Gradient control system for nuclear-magnetic-resonance imaging"

(73) Patentinhaber : Philips Patentverwaltung GmbH
Wendenstrasse 35 Postfach 10 51 49
D-2000 Hamburg 1 (DE)
DE
N.V. Philips' Gloeilampenfabrieken
Groenewoudseweg 1
NL-5621 BA Eindhoven (NL)
FR GB IT NL SE

(72) Erfinder : Kunz, Dietmar
Boxholmstrasse 9
D-2085 Quickborn (DE)

(74) Vertreter : Hartmann, Heinrich, Dipl.-Ing. et al
Philips Patentverwaltung GmbH Wendenstrasse 35
Postfach 10 51 49
D-2000 Hamburg 1 (DE)

## Beschreibung

Die Erfindung betrifft einen Kernspintomographen mit einer Anordnung zur Erzeugung eines homogenen statischen Magnetfeldes und mit drei Spulenanordnungen, die von zeitlich veränderlichen Strömen durchflossen werden und zur Erzeugung von in Richtung des statischen Magnetfeldes verlaufenden Zusatzmagnetfeldern dienen, die sich in drei zueinander senkrechten Richtungen räumlich linear ändern, und mit einer Hochfrequenzspule zur Erzeugung eines hochfrequenten zur Richtung des Hauptfeldes senkrechten Magnetfeldes.

Ein solcher Kernspintomograph ist bekannt — z. B. aus der DE-OS 28 49 355 — und zur Erläuterung in Fig. 1 teilweise aufgebrochen dargestellt. Der Kernspintomograph umfaßt eine Anordnung zur Erzeugung eines starken homogenen statischen Magnetfeldes, das in z-Richtung eines xyz-Koordinatensystems verläuft. Diese Anordnung besteht aus vier zueinander konzentrischen ringförmigen Spulen 1, deren Mittelachse in z-Richtung verläuft. Im Innern dieser Spulen ist das Magnetfeld in einem relativ großen Bereich — dem Untersuchungsbereich — homogen und besitzt eine Flußdichte zwischen 0,1 T und 2 T, wobei die höheren Flußdichten im allgemeinen mit Hilfe einer supraleitenden Spulenanordnung erzeugt werden müssen. Zur Untersuchung wird in diesen Untersuchungsbereich ein auf einem Patientenlagerungstisch 2 mit einer in z-Richtung verfahrbaren Tischplatte 3 befindlicher Patient 4 gebracht.

Außerdem besitzt der Kernspintomograph drei Spulenanordnungen zur Erzeugung von in z-Richtung verlaufenden Magnetfeldern, die sich in der x-, der y- und der z-Richtung räumlich linear ändern. Diese Spulenanordnungen werden in der Literatur in der Regel als « Gradientenspulen » bezeichnet. Die Spulenanordnung zur Erzeugung eines in z-Richtung verlaufenden und in dieser Richtung linear abnehmenden Magnetfeldes besteht aus wenigstens zwei gleichartigen in z-Richtung gegeneinander versetzten und zu den Spulen 1 symmetrisch angeordneten Spulen Gz, zwischen denen ein in z-Richtung verlaufendes und in dieser Richtung sich linear mit dem Ort änderndes Magnetfeld erzeugt wird, wenn diese Spulen gegensinnig von einem Strom durchflossen werden.

Die Spulenanordnung zur Erzeugung eines ebenfalls in z-Richtung verlaufenden Magnetfeldes, das sich jedoch in x-Richtung räumlich linear ändert, besteht aus den vier gleichartigen Spulen Gx. Diese annähernd rechteckigen Spulen sind auf dem Umfang eines Kreiszylinders angeordnet, dessen Mittellinie parallel zur y-Achse ist und das Zentrum der Ringe 1 und damit des Untersuchungsbereiches durchstößt. Die vier Spulen Gx werden von Strömen gleicher Größe durchflossen, die so gerichtet sind, daß in benachbarten Spulen die der jeweils anderen Spule zugewandten, in y-Richtung verlaufenden Teile in derselben Richtung durchströmt werden.

Die Spulenanordnung zur Erzeugung eines in z-Richtung verlaufenden Magnetfeldes, das sich in y-Richtung linear mit dem Ort ändert, hat den gleichen Aufbau wie die Spulenanordnung Gx, ist dieser gegenüber jedoch um 90° gedreht. D. h. auch diese Spulenanordnung besteht aus vier auf dem Umfang eines Kreiszylinders angeordneten Rechteckspulen Gy, wobei die Mittelachse dieses Kreiszylinders jedoch parallel zur x-Achse durch das Zentrum des Untersuchungsbereiches verläuft. Das von den Spulenanordnungen Gx und Gy erzeugte Magnetfeld hat in der in z-Richtung verlaufenden Symmetrieachse die Flußdichte Null.

Schließlich ist noch eine Hochfrequenzspule 5 vorgesehen, die im Untersuchungsbereich ein homogenes hochfrequentes Magnetfeld erzeugt, dessen Frequenz der Larmorfrequenz entspricht, mit der die im Untersuchungsbereich erzeugten Kernspins um die z-Achse präzedieren.

Ein solcher Kernspintomograph besitzt im Prinzip eine große Anzahl von Abbildungsmöglichkeiten. Beispielsweise können im Untersuchungsbereich in einem Volumen des zu untersuchenden Körpers Kernspins angeregt werden, was bei geeigneter Erregung der drei Spulenanordnungen Gx, Gy, Gz die Rekonstruktion der Kernspinverteilung in diesem Volumen erlaubt. Derartige dreidimensionale Abbildungsverfahren sind jedoch sehr zeitaufwendig und haben sich daher in der Praxis nicht durchsetzen können.

Wesentlich häufiger werden zweidimensionale Abbildungsverfahren angewandt, bei denen die Kernspins in lediglich einer Schicht des zu untersuchenden Objektes angeregt werden. Zu diesem Zweck werden während der Anregung der Kernspins durch die Hochfrequenzspule 5 die Spulen Gz durch einen Strom erregt, so daß sich das von den Spulen 1 und Gz erzeugte Magnetfeld von der einen Spule Gz zur anderen linear ändert. Dadurch werden die Kernspins in derjenigen Schicht, deren Larmorfrequenz — die Larmorfrequenz ist bekanntlich der magnetischen Feldstärke proportional — der Frequenz des Hochfrequenzfeldes entspricht. Anschließend werden die Spulen Gx und Gy gleichzeitig oder nacheinander erregt, so daß sich das Magnetfeld innerhalb der Schicht in x- bzw. y-Richtung ändert. Dadurch werden die Phasen und die Amplitude des nach der Anregung in der Spule 5 induzierten Resonanzsignals so beeinflußt, daß die Kernspinverteilung in der angeregten Schicht rekonstruiert werden kann.

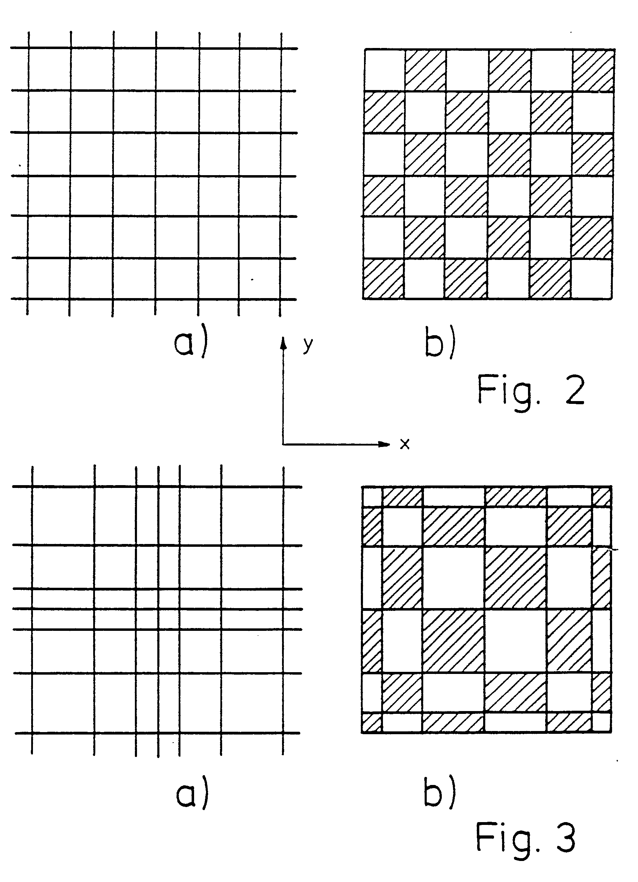

In Fig. 2a ist der räumliche Verlauf der magnetischen Feldstärke in einer x-y-Ebene dargestellt. Die horizontalen Geraden veranschaulichen dabei das Feld der Spulen Gy, wobei sich die magnetische Feldstärke zwischen beliebigen Paaren benachbarter Geraden jeweils um den gleichen Betrag ändert. Das gleiche gilt für die vertikalen Geraden, die das von den Spulen Gx erzeugte

Feld darstellen und jeweils die Orte gleicher magnetischer Feldstärke dieser Spule miteinander verbinden. Man erkennt, daß für beide Spulen der räumliche Abstand zweier benachbarter Linien gleicher magnetischer Feldstärke, zwischen denen ein bestimmter Feldstärkeunterschied besteht, in jeder Richtung für jedes benachbarte Linienpaar jeweils konstant ist. Dies ist eine Folge davon, daß sich das von den Spulen Gx und Gy erzeugte Feld in x- bzw. y-Richtung räumlich linear ändert bzw. in diesen Richtungen einen konstanten Gradienten hat. Würde man mit Hilfe derartiger Felder ein Objekt untersuchen, das in einer xy-Ebene eine schachbrettartige Kernspinverteilung aufweist, dann würde mit Hilfe der bei der Untersuchung in der Hochfrequenzspule 5 induzierten Signale eine Kernspindichteverteilung rekonstruiert werden, die ebenfalls schachbrettartig ist und die in Fig. 2b dargestellt ist. In der Praxis würde sich allerdings die Abbildung von der tatsächlichen Dichteverteilung aufgrund des begrenzten räumlichen Auflösungsvermögens eines solchen Kernspintomographen unterscheiden.

Eine Verbesserung des Auflösungsvermögens würde u. a. eine Vergrößerung der Meßzeiten erfordern, die ohnehin schon relativ groß sind oder aber eine Vergrößerung des Magnetfeldgradienten bedingen, was eine Vergrößerung der Bandbreite des empfangenen Signals zur Folge hätte, wodurch das Signalrauschverhältnis wiederum verschlechtert würde.

Aufgabe der vorliegenden Erfindung ist es, einen Kernspintomographen der eingangs genannten Art so auszugestalten, daß in einem vom Benutzer vorgebbaren Teils des Untersuchungsbereichs das Auflösungsvermögen verbessert wird. Diese Aufgabe wird erfindungsgemäß durch die im Kennzeichen des Anspruchs 1 angegebenen Maßnahmen gelöst. Eine weitere Ausgestaltung ist im Anspruch 2 angegeben.

Während man also bei allen bisher bekannten Kernspintomographen bemüht war, die Spulenanordnungen so auszulegen, das sich ein möglichst konstanter Gradient des Magnetfeldes ergab bzw. dieses sich möglichst linear räumlich änderte, geht die Erfindung einen anderen Weg und verwendet (wenigstens) zwei weitere Spulenanordnungen zur Erzeugung von dem statischen Magnetfeld parallelen Magnetfeldern, die sich in der gleichen Richtung, jedoch in unterschiedlicher Weise räumlich nichtlinear ändern. Während bei den bekannten Kernspintomographen das Auflösungsvermögen räumlich konstant ist, ändert es sich bei der Erfindung entsprechend dem Gradienten des Magnetfeldes, d. h. in einem Bereich, in dem der Gradient des Magnetfeldes groß ist, ist auch das Auflösungsvermögen groß und in einem Bereich mit kleinem Gradienten des Magnetfeldes ist das Auflösungsvermögen klein.

Durch Änderung der Amplitude der Ströme durch die verschiedenen Spulenanordnungen läßt sich dabei die räumlich Lage z. B. des Maximums des Magnetfeldgradienten vorgebenen Anforderungen anpassen. Das bedeutet, daß die Lage des Teils des Untersuchungsbereiches in dem das Auflösungsvermögen besonders groß ist, entsprechend den jeweiligen Anforderungen variiert werden kann. Dies ist grundsätzlich bei dreidimensionalen Abbildungsverfahren, insbesondere aber auch bei zweidimensionalen Abbildungsverfahren möglich.

Aus J. Phys. E. Sci. Instrum., Vol. 16, 1983, Seiten 34 bis 38, und aus Phys. Med. Biol., 1983, Vol. 28, No. 8, Seiten 925 bis 938, ist es bekannt, daß sich bei der Rekonstruktion Störungen ergeben können, wenn der Gradient des Magnetfeldes nicht über den gesamten Untersuchungsbereich konstant ist. Solche unerwünschten Inhomogenitäten ergeben sich bei kompakt aufgebauten Gradientenspulen, wobei der Gradient an den Rändern des Untersuchungsbereiches größer ist als in dessen Mitte. In diesen Veröffentlichungen ist auch angegeben, daß die dadurch bedingte Rekonstruktionsfehler durch einen geeigneten Rekonstruktionsalgorithmus beseitigt werden können, falls für jeden Punkt des Untersuchungsbereiches der Gradient genau bekannt ist. — Weiterhin ist aus der DE-A-3 316 722 ein Kernspintomograph mit mehreren Gradientenspulenpaaren bekannt, wobei darauf hingewiesen ist, daß der Strom durch die Spulenpaare gleich sein muß, da andernfalls der magnetische Gradient nicht konstant ist und das sich ergebende Bild in einigen Bereichen komprimiert oder expandiert erscheint.

Demgegenüber wird bei der Erfindung die Nichtlinearität durch Verwendung (wenigstens) zweier weiterer Spulenanordnungen bewußt gesteigert, um in einem wählbaren Bereich eine Verbesserung des Auflösungsvermögens zu erhalten. Die Ströme durch die drei Spulenanordnungen können dabei — in bekannter Weise — durch einen Computer gesteuert werden ; das Gleiche gilt für die Ströme durch die weiteren Spulenanordnungen.

Das Ausmaß, in dem der Gradient des Magnetfeldes sich räumlich ändert, kann durch die Konstanten a, b und c bei jeder Untersuchung gesondert bestimmt werden. Sind beispielsweise alle drei Konstanten Null, ist das von der weiteren Spulenanordnung erzeugte Magnetfeld ebenfalls Null, so daß nur die von den drei Spulenanordnungen erzeugten Magnetfelder mit konstantem Gradienten das Abbildungsverfahren bestimmen. Der entgegengesetzte Extremfall ergibt sich, wenn der Strom i1, i2 oder i3 anstatt durch die zugeordnete Spulenanordnung mit räumlich konstanten Gradienten die weitere Spulenanordnung durchfließt. In diesem Fall wäre also einer der Koeffizienten a, b, oder c unendlich bzw. sehr groß.

Die Erfindung wird nachstehend anhand der Zeichnung näher erläutert. Es zeigen

Fig. 1 eine perspektivische Ansicht eines bekannten Kernspintomographen,

Fig. 2a den räumlichen Verlauf der magnetischen Feldstärke in einer xy-Ebene und Fig. 2b die mit einer derartigen Anordnung rekonstruierte Kernspinverteilung,

Fig. 3a den räumlichen Verlauf der magnetischen Feldstärke bei der Erfindung,

Fig. 3b die Rekonstruktion einer schachbrettartigen Kernspinverteilung mit einem erfindungsgemäßen Kernspintomographen,

Fig. 4 ein Blockschaltbild für einen erfindungsgemäßen Kernspintomographen.

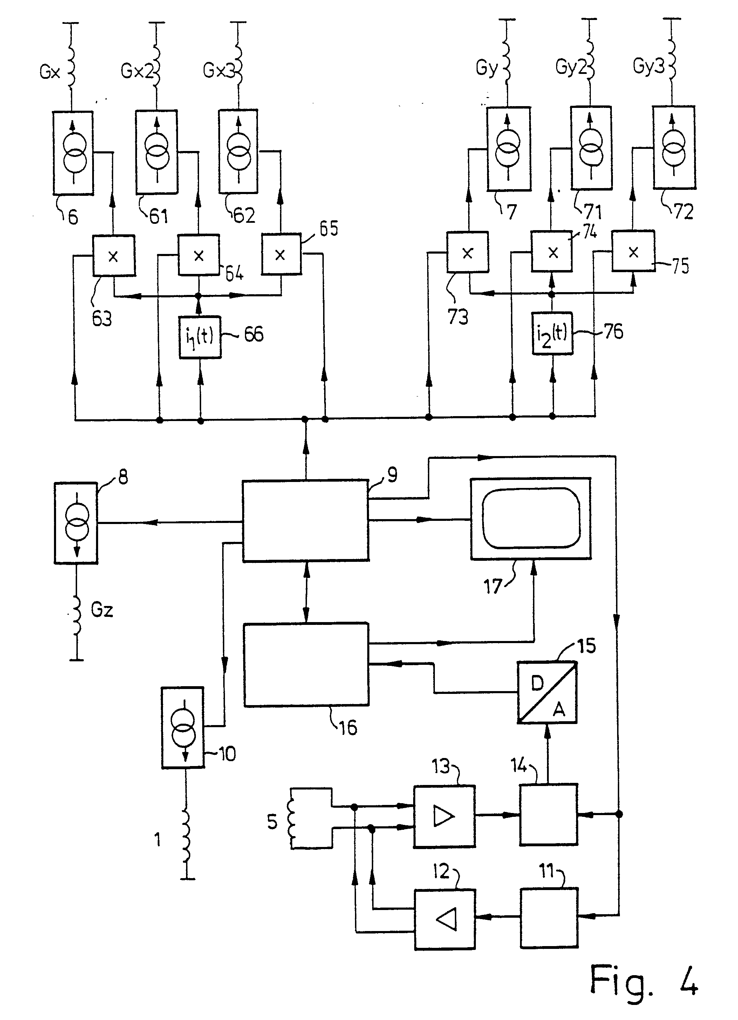

Der Strom für die Spulenanordnungen Gx, Gy, Gz wird von Stromquellen 6, 7 und 8 geliefert, die von einer zentralen Steuereinheit 9 gesteuert werden (Fig. 4). Diese steuert auch eine Stromquellenanordnung 10 zur Erzeugung von Gleichströmen für die Spulen 1, die das statische in z-Richtung verlaufende Magnetfeld erzeugen. Ein Modulator 11 erzeugt eine Trägerschwingung, die über einen Leistungsverstärker 12 der Hochfrequenzspule 5 zugeführt wird, wobei die Frequenz der modulierten Schwingung sowie die Größe des durch die Spulen 1 erzeugten Magnetfeldes so aufeinander abgestimmt sind, daß in einer Schicht des untersuchten Körpers 4 Kernspinresonanz angeregt wird. Die im Anschluß an diese Anregung in der Spule 5 induzierten Signale werden über einen Verstärker 13 einem phasenempfindlichen Demodulator zugeführt, dessen Ausgangssignal von einem Digital-Analog-Wandler 15 in ein digitales Datenwort umgesetzt und einer Rekonstruktionseinheit 16 zugeführt. Diese ermittelt aus den zugeführten Daten nach einem vorgegebenen Algorithmus die räumliche Verteilung der Kernspins in der angeregten Schicht und diese Verteilung wird beispielsweise mittels eines Monitors 17 dargestellt.

Insoweit als bisher beschrieben ist auch diese Anordnung bekannt.

Erfindungsgemäß sind jedoch vier zusätzliche Spulenanordnungen Gx2, Gx3, Gy2 und Gy3 vorgesehen, die an steuerbare Stromquellen 61, 62, 71 bzw. 72 angeschlossen sind. Die Spulen Gx2 und Gy2 erzeugen ein Magnetfeld, das parallel zur z-Achse gerichtet ist und dessen Stärke sich in x- bzw. y-Richtung quadratisch mit dem Ort ändert, wobei in der zur z-Achse parallelen Symmetrieachse die magnetische Feldstärke Null ist. Die Spulen Gx3 und Gy3 erzeugen ein in z-Richtung verlaufendes Magnetfeld, dessen Feldstärke sich in x- bzw. in y-Richtung mit der dritten Potenz des Ortes ändert.

Spulen zur Erzeugung von in z-Richtung verlaufenden Magnetfeldern, deren Feldstärke sich entweder in x- oder in y-Richtung nichtlinear mit dem Ort ändert, sind bei Kernspinresonanzgeräten an sich bekannt. Sie werden als Korrekturspulen (shim coils) benutzt, um Inhomogenitäten des statischen Magnetfeldes zu beseitigen. Derartige Spulenanordnungen sind in « The Review of Scientific Instruments » Vol. 23, Nummer 3, März 1961, Seiten 241 bis 250, in der US-PS 3 582 779 und der DE-OS 19 46 059 beschrieben. Daß sich bei derartigen Spulenanordnungen das Feld nicht nur in einer der beiden Richtungen (x bzw. y), sondern auch in z-Richtung ändern kann, stört bei Kernspintomographen, bei denen eine in der x-y-Ebene liegende Schicht untersucht wird, nicht, weil für diese Schicht z = const. gilt.

Die Stromquellen 6, 61 und 62 werden von der zentralen Steuereinheit 9 derart gesteuert, daß der Strom durch die Spulen Gx, Gx2 und Gx3 denselben zeitlichen Verlauf hat, jedoch eine unterschiedliche — einstellbare — Amplitude. Dieses Ziel läßt sich mit Hilfe von drei Multiplizierstufen 63, 64, 65 erreichen, deren Ausgänge mit den Steuereingängen der Stromquellen 6, 61 bzw. 62 verbunden sind und in denen das Signal eines Funktionsgenerators 66 mit von der Steuereinheit erzeugten Faktoren multipliziert wird, die das Gewicht darstellen, mit denen das Feld der jeweiligen Spule Gx, Gx2 bzw. Gx3 wirksam wird. Wie bereits erwähnt, führen dadurch alle Spulenanordnungen Gx, Gx2 und Gx3 Ströme mit dem gleichen Verlauf, deren Amplituden jedoch durch die zentrale Steuereinheit 9 einstellbar sind.

In ähnlicher Weise sind die Steuereingänge der Spulenanordnungen Gy, Gy2 und Gy3 mit Ausgängen der Multiplizierstufen 73, 74 und 75 verbunden, in denen das von einem Funktionsgenerator 76 erzeugte, den zeitlichen Verlauf aller drei Ströme bestimmende Ausgangssignal mit den von der zentralen Steuereinheit 9 bestimmten Gewichtungsfaktoren multipliziert wird, so daß auch die Ströme durch diese Spulen den gleichen zeitlichen Verlauf aber eine unterschiedliche Amplitude aufweisen.

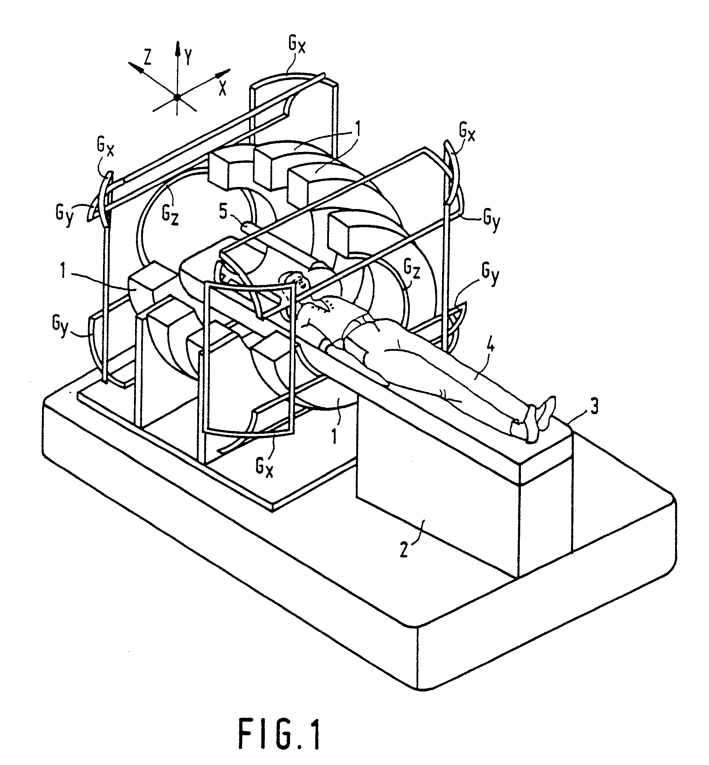

Wenn die Faktoren für die Multiplizierstufen 64, 65 sowie 74 und 75 so gewählt sind, daß die Ströme der Stromquellen 61, 62 sowie 71 und 72 Null werden, ergibt sich kein Unterschied gegenüber dem zuvor anhand der Fig. 1 erläuterten Kernspintomographen. Insbesondere haben die von den Gradienten-Spulenanordnungen Gx, Gy erzeugten Magnetfelder den in Fig. 2 dargestellten Feldstärkenverlauf und eine schachbrettartige Kernspinverteilung in dem untersuchten Objekt wird gemäß Fig. 2b wiedergegeben.

Sind die von den Stromquellen 61, 62 bzw. 71, 72 erzeugten Ströme hingegen von Null verschieden, ergibt sich ein abweichendes Bild. Die magnetische Feldstärke ändert sich dann nicht mehr linear in der xy-Ebene und es gilt dann Fig. 3a, wobei wiederum in einer xy-Ebene die Orte gleicher magnetischer Feldstärke durch eine Linie (Gerade) miteinander verbunden sind und zwei beliebige benachbarte Linien jeweils einem bestimmten Feldstärkeunterschied entsprechen (wobei davon ausgegangen ist, daß die Ströme durch die Spulen Gy, Gy2 und Gy3 abgeschaltet sind, wenn die Ströme durch die Spulen Gx, Gx2 und Gx3 fließen — und umgekehrt). Man erkennt, daß der räumliche Abstand zwischen zwei benachbarten Linien sowohl in x- als auch in y-Richtung außen groß und innen klein ist, d. h. der Gradient der magnetische Feldstärke hat sein Maximum im Zentrum. Untersucht man mit in der aus Fig. 3a ersichtlichen Weise in x- und y-Richtung veränderlichen Magnetfeldern ein Objekt mit schachbrettartig verteilter Kernspindichte und rekonstruiert man aus den dabei in der Spule 5 induzierten Signalen in der üblichen Weise die Kernspindichteverteilung in der untersuchten Ebene, erhält man als Ergebnis die in Fig. 3b dargestellte Verteilung. Man erkennt im Vergleich zu Fig. 2b, daß die Struktur im Zentrum größer wiedergegeben wird, während die Strukturen am Rande kleiner wiedergegeben werden.

Ein ähnliches Bild würde sich ergeben, wenn man ein Schachbrett mit Hilfe eines sogenannten Fischaugen-Objektives abbilden würde. Es läßt sich darüber hinaus zeigen, daß in gleichem Maße wie in der Abbildung die Größe der inneren Bereiche zu- und die der äußeren Bereiche abnimmt die aus den in der Spule 5 induzierten Signalen erhaltenen Informationen über diese Bereiche zu- bzw. abnehmen. Über die zentralen Bereiche wird also vergleichsweise viel Information erhalten — zu Lasten der äußeren Bereiche, über die relativ wenig Information erhalten wird (im Vergleich zu der Rekonstruktion nach Fig. 2b, wobei die erhaltene Information für alle Bereiche gleich ist). Das bedeutet, daß das Auflösungsvermögen im Zentrum verbessert ist — auf Kosten des Auflösungsvermögens an den Rändern.

Die aus Fig. 3b ersichtliche geometrische Verzerrung der rekonstruierten Kernspindichteverteilung gegenüber der tatsächlichen Verteilung kann ggf. durch Änderung des Rekonstruktionsalgorithmus wieder beseitigt werden. Da nämlich die Amplitude der Ströme durch die Spulenanordnungen Gx2 und Gx3 bzw. Gy2 und Gy3 bekannt ist, ist auch das Ausmaß der geometrischen Verzerrung festgelegt, so daß der Rekonstruktionsalgorithmus so geändert werden kann, daß diese Verzerrungen beseitigt werden. Anstelle von Fig. 3b würde sich dann eine Rekonstruktion ergeben, die wiederum einer schachbrettartigen Verteilung entspräche. Im Unterschied zu Fig. 2b wäre die Informationsdichte, d. h. das räumliche Auflösungsvermögen im Zentrum dabei jedoch größer als am Rande, d. h. im Zentrum befindliche Details würden schärfer abgebildet als die am Rande.

Vorstehend war angenommen worden, daß der Gradient der magnetischen Feldstärke im Zentrum (x = 0, y = 0) am größten ist, so daß infolgedessen auch das Auflösungsvermögen im Zentrum am größten ist. Dies gilt indes nur für eine bestimmte Kombination der Ströme durch die Spulenanordnungen Gx, Gx2 und Gx3 bzw. Gy, Gy2 und Gy3. Bei jeder anderen Kombination ändert sich die Lage des maximalen Gradienten in x- und in y-Richtung. Da diese Kombinationen durch die Steuereinrichtung 9 bestimmt werden, kann mit deren Hilfe die Lage der Gradientenmaxima bzw. des Bereichs mit der höchsten räumlichen Auflösung den jeweiligen Erfordernissen angepaßt werden.

In besonderen Fällen kann der Strom durch die Spulenanordnungen Gx und Gy zu Null gemacht werden, während der Strom durch wenigstens eine der Spulenanordnungen Gx2 und Gx3 bzw. Gy2 und Gy3 von Null verschieden ist. In diesem Fall würde sich das Gradientenfeld in x- und in y-Richtung ausschließlich nichtlinear ändern.

Anstelle von Spulenanordnungen, bei denen sich die magnetische Feldstärke in x- bzw. y-Richtung quadratisch oder kubisch ändert, können auch Spulenanordnungen verwendet werden, bei denen sich die magnetische Feldstärke in anderer Weise nichtlinear mit dem Orte ändert. Auch dann ließe sich die Lage der Gradientenmaxima durch Änderung der diesen Spulenanordnungen zugeführten Kombination von Strömen ändern. Darüber hinaus ist es auch möglich, eine oder mehrere Spulenanordnungen zu verwenden, die ein in z-Richtung verlaufendes Magnetfeld erzeugen, dessen Feldstärke sich in x- und in y-Richtung nichtlinear ändert.

Bei der Anordnung nach Fig. 4 werden die Spulen Gx2 und Gx3 von einem Strom durchflossen, der nur von dem Strom abhängt, der durch die Spule Gx fließt, während die Spulen Gy2 und Gy3 von einem Strom durchflossen werden, der den gleichen zeitlichen Verlauf hat wie der Strom durch die Spule Gy, vom Strom durch die Spule Gx aber unabhängig ist. Grundsätzlich ist es auch möglich, den Strom durch jede der Spulen Gx2, Gx3, Gy2 und Gy3 aus einer Linearkombination des Stromes i1 durch die Spule Gx und des Strom i2 durch die Spule Gy zu bilden, so daß gilt

$$i = ai1 + bi2$$

im zweidimensionalen Fall, und im dreidimensionalen Fall

$$i = ai1 + bi2 + ci3,$$

wobei i3 der Strom durch die Spule Gz ist. Für jede der Spulen kann dabei ein anderer Satz von Koeffizienten a, b, c gelten. Jedoch erleichtert es die Interpretation des verzerrten Bildes (vgl. Fig. 3b) bzw. dessen nachträgliche Entzerrung, wenn die Ströme durch die Spulen mit räumlich nichtlinear veränderlichem Magnetfeld (z. B. durch Gx2, Gx3) den gleichen zeitlichen Verlauf haben wie der Strom durch die Spule (Gx), deren Magnetfeld seine Feldstärke in der gleichen Richtung — allerdings räumlich linear — ändert.

## Patentansprüche

1. Kernspintomograph mit einer Anordnung (1) zur Erzeugung eines homogenen statischen Magnetfeldes und mit drei Spulenanordnungen (Gx, Gy, Gz), die von zeitlich veränderlichen Strömen durchflossen werden und zur Erzeugung von in Richtung des statischen Magnetfeldes verlaufenden Zusatzmagnetfeldern dienen, die sich in drei zueinander senkrechten Richtungen (x, y, z) räumlich linear ändern, und mit einer Hochfrequenzspule (5) zur Erzeugung eines hochfrequenten, zur Richtung des Hauptfeldes senkrechten Magnetfeldes, dadurch gekennzeichnet, daß wenigstens zwei weitere Spulenanordnungen (Gx2, Gx3 bzw. Gy2, Gy3) zur Erzeugung von dem statischen Magnetfeld parallelen Magnetfeldern vorgesehen sind, die sich in der gleichen Richtung, jedoch in unterschiedlicher Weise räumlich nichtlinear ändern, daß der Strom durch jede dieser Spulenanordnungen der Bedingung

$$i = ai1 + bi2 + ci3$$

genügt, wobei a, b, c Konstanten sind und i1, i2, i3 die Ströme durch die drei Spulenanordnungen (Gx, Gy, Gz), und daß die Ströme durch die beiden weiteren Spulenanordnungen den gleichen zeitlichen Verlauf, aber eine einstellbare Amplitude haben.

2. Kernspintomograph nach Anspruch 1, dadurch gekennzeichnet, daß diejenige der drei Spulenanordnungen (Gx bzw. Gy), die während der Anregung der Hochfrequenzspule (5) nicht erregt ist und deren Magnetfeld sich in der gleichen Richtung räumlich linear ändert, in der sich die Magnetfelder der beiden Spulenanordnungen räumlich nichtlinear ändern, von einem Strom (i1 bzw. i2) durchflossen wird, der den gleichen zeitlichen Verlauf hat wie der Strom durch die beiden weiteren Spulenanordnungen (Gx2, Gx3 bzw. Gy2, Gy3).

**Claims**

1. A nuclear magnetic resonance tomograph, comprising an arrangement (1) for generating a homogeneous steady magnetic field and three coil systems (Gx, Gy, Gz) wherethrough currents flow which vary in time and which serve to generate additional magnetic fields which extend in the direction of the steady magnetic field and which vary linearly in space in three mutually perpendicular directions (x, y, z), and also comprising an RF coil (5) for generating an RF magnetic field perpendicularly to the direction of the main field, characterized in that there are provided at least two further coil systems (Gx2, Gx3 or Gy2, Gy3) for generating magnetic fields which extend parallel to the steady magnetic field and which vary non-linearly in space in the same direction but in a different manner, the current through each of these coil systems satisfying the condition

$$i = ai1 + bi2 + ci3$$

where a, b, c are constants and i1, i2 and i3 are the currents through the three coil systems (Gx, Gy, Gz), the currents through the two further coil systems exhibiting the same variation in time but an adjustable amplitude.

2. A nuclear magnetic resonance tomograph as claimed in Claim 1, characterized in that that one of the three coil systems (Gx or Gy) which is not energized during the energising of the RF coil (5) and whose magnetic field varies linearly in space in the same direction as that in which the magnetic fields of the two coil systems vary non-linearly in space, conducts a current (i1 or i2) which exhibits the same variation in time as the current through the two further coil systems (Gx2, Gx3 or Gy2, Gy3).

**Revendications**

1. Tomographe à résonance magnétique nucléaire comprenant un dispositif (1) pour créer un champ magnétique statique homogène et trois dispositifs de bobines (Gx, Gy, Gz) qui sont parcourus par des courants variables dans le temps et servent à créer des champs magnétiques supplémentaires s'étendant dans la direction du champ magnétique statique, qui varient linéairement dans l'espace dans trois directions mutuellement perpendiculaires (x, y, z), ainsi qu'une bobine de haute fréquence (5) pour créer un champ magnétique de haute fréquence perpendiculaire à la direction du champ magnétique principal, caractérisé en ce qu'il est prévu au moins deux autres dispositifs de bobines (Gx2, Gx3 et Gy2, Gy3) pour la création de champs magnétiques parallèles au champ magnétique statique, qui varient de façon non linéaire dans l'espace dans la même direction, mais de façon différente, que le courant passant par chacun de ces dispositifs de bobines satisfait à la condition

$$i = ai1 + bi2 + ci3$$

où a, b et c sont des constantes et i1, i2 et i3 sont les courants passant par les trois dispositifs de bobines (Gx, Gy, Gz), et que les courants passant par les deux dispositifs de bobines supplémentaires ont le même laps de temps, mais une amplitude réglable.

2. Tomographe à résonance magnétique nucléaire suivant la revendication 1, caractérisé en ce que celui des trois dispositifs de bobines (Gx et Gy) qui n'est pas excité pendant l'excitation de la bobine à haute fréquence (5) et dont le champ magnétique varie linéairement dans l'espace dans la même direction que celle dans laquelle les champs magnétiques des deux dispositifs de bobines varient de façon non linéaire dans l'espace est parcouru par un courant (i1 ou i2) qui a le même laps de temps que le courant passant par les deux autres dispositifs de bobines (Gx2, Gx3 et Gy2, Gy3).

FIG.1

a)

b)

Fig. 2

y

x

a)

b)

Fig. 3

Fig. 4